# EUROPEAN PATENT APPLICATION

(11) **EP 4 709 103 A1**
(43) Date of publication of application: **11.03.2026**
(21) Application number: 24855752.2
(22) Date of filing: 16.08.2024
(51) Int. Cl.: H10F 77/20, B62M 6/85

(54) **BACK CONTACT BATTERY, BATTERY ASSEMBLY, AND PHOTOVOLTAIC SYSTEM**

(30) Priority: 22.08.2023 CN 202322268675 U
(71) Applicant: Zhuhai Fushan Aiko Solar Energy Technology Co., Ltd., FushanIndustrial Park, Doumen District Zhuhai Guangdong 519000 (CN); Shenzhen Aiko Digital Energy Technology Co., Ltd., Shenzhen, Guangdong 518000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Zhejiang Aiko Solar Energy Technology Co., Ltd., Yiwu, Jinhua Zhejiang 322000 (CN)
(72) Inventor: TAN, Lixiang, Zhuhai, Guangdong 519000 (CN); ZHANG, Lingjie, Zhuhai, Guangdong 519000 (CN); WANG, Shuai, Zhuhai, Guangdong 519000 (CN); WANG, Yongqian, Zhuhai, Guangdong 519000 (CN); CHEN, Gang, Zhuhai, Guangdong 519000 (CN)
(74) Representative: EP&C
(86) International application number: PCT/CN2024/112897
(87) International publication number: WO 2025/040029

(57) **Abstract**

There are a back contact cell, a cell assembly, and a photovoltaic system. The back contact cell includes a substrate and at least one transparent protrusion. Two kinds of fingers distributed in a staggered manner are formed on a back surface of the substrate, the at least one transparent protrusion is provided on a front surface of the substrate, a thickness of each transparent protrusion is 28 µm-98 µm, and a ratio of a total coverage area of the at least one transparent protrusion on the front surface to a total area of the front surface is 1%-4%. In this way, since each transparent protrusion, which is disposed on the front surface of the substrate, has the thickness of 28 µm-98 µm, and the total coverage area of the at least one transparent protrusion having the ratio of 1 %-4% with respect to the total area of the front surface, when another cell is stacked on the front surface of the back contact cell, there will be a gap between the two cells, so as to prevent the cell stacked on the front surface of the back contact cell from scratching the front surface of the back contact cell, thereby facilitating improvement of the quality of the back contact cell.

## Description

### Technical Field

The present disclosure relates to the technical field of solar cells, and in particular, to a back contact cell, a cell assembly, and a photovoltaic system.

### Background

Electricity generated by solar cells is a sustainable clean energy source. By virtue of a photovoltaic effect of a semiconductor p-n junction, sunlight can be converted into electric energy. A solar cell in which electrodes with two polarities both are formed on a back surface of the cell is a back contact cell.

In the related technology, a plurality of back contact cells are transported or stored in a stacking manner. However, a front surface of the back contact cell is easily scratched by a back surface of another back contact cell.

Based on this, how to prevent the front surface of the back contact cell from being scratched becomes an urgent problem to be solved.

### Summary

The present disclosure provides a back contact cell, a cell assembly, and a photovoltaic system, so as to solve the problem of how to prevent a front surface of a back contact cell from being scratched.

The back contact cell provided in the present disclosure includes a substrate and at least one transparent protrusion, wherein two kinds of fingers distributed in a staggered manner are formed on a back surface of the substrate, the at least one transparent protrusion is formed on a front surface of the substrate, a thickness of each transparent protrusion is 28 µm-98 µm, and a ratio of a total coverage area of the at least one transparent protrusion on the front surface to a total area of the front surface is 1%-4%.

Optionally, the at least one transparent protrusion includes at least one first protrusion, and the first protrusion is in a strip shape, and an extending direction of the first protrusion is perpendicular to an extending direction of the finger.

Optionally, a width of each first protrusion is 0.1 mm-2 mm.

Optionally, a ratio of a length of each first protrusion to a length of the front surface is greater than or equal to 18%.

Optionally, the at least one transparent protrusion includes at least one second protrusion, and an extending direction of the second protrusion is parallel to an extending direction of the finger.

Optionally, the at least one transparent protrusion includes at least one third protrusion, and the third protrusion is distributed along at least one diagonal of the front surface.

Optionally, the at least one transparent protrusion includes fourth protrusions, and each of the fourth protrusions is in a dot shape

Optionally, an area of each of the fourth protrusions is 2 mm²-6 mm².

A cell assembly provided in the present disclosure includes the back contact cell described in any one of the above.

A photovoltaic system provided in the present disclosure includes the cell assembly described in the above.

According to the back contact cell, cell assembly, and photovoltaic system in the embodiments of the present disclosure, since each transparent protrusion, which is disposed on the front surface of the substrate, has the thickness of 28 µm-98 µm, and the total coverage area of the at least one transparent protrusion having the ratio of 1 %-4% with respect to the total area of the front surface, when another cell is stacked on the front surface of the back contact cell, there will be a gap between the two cells, so as to prevent the cell stacked on the front surface of the back contact cell from scratching the front surface of the back contact cell, thereby facilitating improvement of the quality of the back contact cell.

### Brief Description of the Drawings

Fig. 1 is a schematic structural diagram of a back contact cell according to an embodiment of the present disclosure.
Fig. 2 is a schematic structural diagram of a back contact cell according to an embodiment of the present disclosure.
Fig. 3 is a schematic structural diagram of a back contact cell according to an embodiment of the present disclosure.
Fig. 4 is a schematic structural diagram of a back contact cell according to an embodiment of the present disclosure.
Fig. 5 is a schematic structural diagram of a back contact cell according to an embodiment of the present disclosure.
Fig. 6 is a schematic structural diagram of a back contact cell according to an embodiment of the present disclosure.

In the drawings:
10. back contact cell; 11. substrate; 121. first protrusion; 122. second protrusion; 123. third protrusion; 124. fourth protrusion.

### Detailed Description of the Embodiments

To make the objectives, technical solutions and advantages of the present disclosure clearer, the present disclosure is further described in detail. Examples of the embodiments are shown in the accompanying drawings, where the same or similar reference numerals throughout the present disclosure represent the same or similar elements or the elements having the same or similar functions. The embodiments described below with reference to the accompanying drawings are exemplary, and are only intended to be illustrative of the present disclosure and cannot be construed as limiting the present disclosure. In addition, it should be understood that specific embodiments described herein are merely intended to explain the present disclosure instead of limiting the present disclosure.

In the description of the present disclosure, it is understood that orientation or position relationships indicted by terms such as "length", "width", "up", "below", "left", "right", "horizontal", "top", "bottom", and the like are based on orientation or position relationships shown in the drawings, are merely to facilitate the description of the present disclosure and simplify the description, instead of indicating or implying that the indicated device or element must have particular orientations or be constructed and operated in particular orientations, and cannot be construed as limiting the present disclosure.

In addition, the terms "first" and "second" are used for descriptive purposes only and are not to be construed as indicating or implying relative importance or implicitly specifying the number of technical features indicated. Thus, features defined by "first" and "second" may explicitly or implicitly comprise one or more of the features. In the description of the present disclosure, the meaning of "a plurality of" is two or more, unless explicitly and specifically defined otherwise.

In the description of the present disclosure, it is to be noted that, unless otherwise clearly specified and limited, the terms "mounted", "connected" and "connect" should be interpreted broadly. For example, the term "connect" may be fixed connection, detachable connection or integral construction. As an alternative, the term "connect" may be mechanical connection, or electrical connection, or mutual communication. As an alternative, the term "connect" may be direct connection, or indirect connection through a medium, or communication in two elements or the interaction between two components. For those of ordinary skill in the art, specific meanings of the foregoing terms in the present disclosure may be understood based on specific situations.

In the present disclosure, unless otherwise explicitly specified and defined, a first feature being "over" or "below" a second feature may mean that the first feature and the second feature are in direct contact, or the first feature and the second feature are not in direct contact but are in contact through another feature there between. Moreover, the first feature being "over", "above", and "on" the second feature includes that the first feature is directly above or obliquely above the second feature, or merely means that the first feature has a larger horizontal height than the second feature. The first feature being "beneath", "under" and "below" the second feature including the first feature being right under or at an inclined lower portion of the second feature, or simply indicating that the horizontal height of the first feature is less than that of the second feature.

The following disclosure provides many different embodiments or examples for achieving different structures of the present disclosure. In order to simplify the present disclosure of the present disclosure, components and settings of specific examples are described below. Certainly, they are merely examples, and are not intended to limit the present disclosure. In addition, the present disclosure may repeat reference numerals and/or reference letters in different examples. The repetition is for the purpose of simplification and clarity, but does not indicate a relationship between the various embodiments and/or settings discussed. In addition, the present disclosure provides examples of various specific processes and materials, but those of ordinary skill in the art may be aware of the application of other processes and/or usage scenarios of other materials.

In the present disclosure, since each transparent protrusion, which is disposed on the front surface of the substrate, has the thickness of 28 µm-98 µm, and the total coverage area of the at least one transparent protrusion having the ratio of 1 %-4% with respect to the total area of the front surface, when another cell is stacked on the front surface of the back contact cell, there will be a gap between the two cells, so as to prevent the cell stacked on the front surface of the back contact cell from scratching the front surface of the back contact cell, thereby facilitating improvement of the quality of the back contact cell.

### Embodiment 1

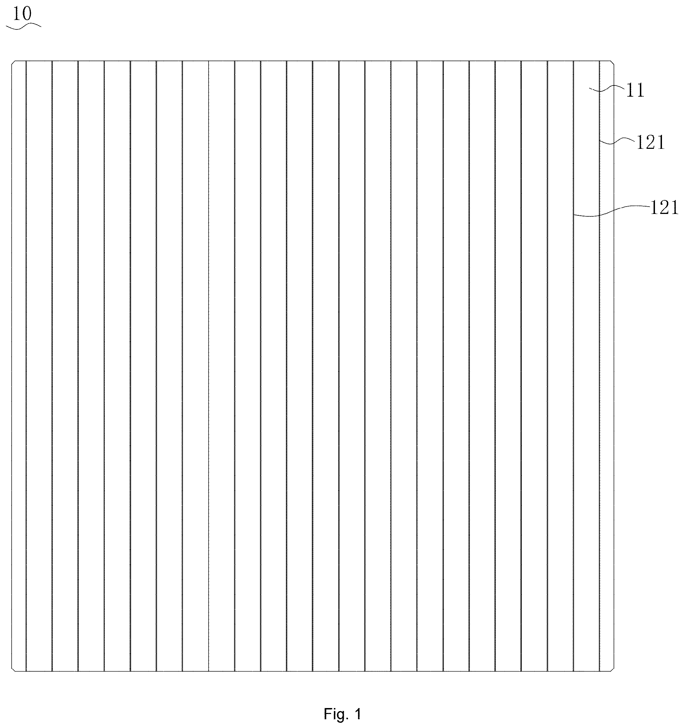

Referring to Fig. 1, Fig. 2, Fig. 3, Fig. 4, Fig. 5, and Fig. 6, a back contact cell 10 provided in the present disclosure includes a substrate 11 and at least one transparent protrusion. Two kinds of fingers distributed in a staggered manner are formed on a back surface of the substrate 11, the at least one transparent protrusion is formed on a front surface of the substrate 11, a thickness of each of the transparent protrusion is 28 µm-98 µm, and a ratio of a total coverage area of the at least one transparent protrusion on the front surface to a total area of the front surface is 1%-4%.

According to the back contact cell 10 in this embodiment of the present disclosure, since each transparent protrusion, which is disposed on the front surface of the substrate 11, has the thickness of 28 µm-98 µm, and the total coverage area of the at least one transparent protrusion having the ratio of 1%-4% with respect to the total area of the front surface, when another cell is stacked on the front surface of the back contact cell 10, there will be a gap between the two cells, so as to prevent the cell stacked on the front surface of the back contact cell 10 from scratching the front surface of the back contact cell, thereby facilitating improvement of the quality of the back contact cell 10.

Specifically, the substrate 11 of the back contact cell 10 can include a silicon substrate, conductive regions with two polarities distributed in a staggered manner and fingers with two polarities distributed in a staggered manner can be formed on a back surface of the silicon substrate, a back-side surface passivation layer can also be formed on the back side of the silicon substrate, and a front-side surface passivation layer can be formed on a front side of the silicon substrate. The surface passivation layer is, for example, but not limited to, a silicon nitride layer, a silicon oxynitride layer, or a silicon oxide layer. busbars may or may not be formed on a back surface of the substrate 11, and only fingers are formed. In other words, the back contact cell 10 may be a cell with busbars, or may be a cell without busbars. A specific structure of the substrate 11 of the back contact cell 10 is not limited herein.

Specifically, the thickness of each of the transparent protrusion is, for example, 28 µm, 30 µm, 32 µm, 40 µm, 60 µm, 65 µm, 73 µm, 90 µm, or 98 µm. The thickness of the transparent protrusion is not limited specifically herein.

It can be understood that, the thickness of each of the transparent protrusion is 28 µm-98 µm can cause the thickness of the transparent protrusion to be within an appropriate range, so that a small gap with another cell and a poor anti-scratching effect caused by a too small thickness of the transparent protrusion can be avoided, and raw material waste and increased costs caused by an excessive thickness of the transparent protrusion can also be avoided.

Optionally, the thickness of each of the transparent protrusion is 60 µm-65 µm, for example, it can be 60 µm, 61 µm, 62 µm, 63 µm, 64 µm, or 65 µm. Therefore, scratching prevention and cost reduction can be taken into consideration, thereby achieving an optimal overall effect.

Specifically, the ratio of the total coverage area of the at least one transparent protrusion on the front surface to the total area of the front surface is, for example, 1%, 1.2%, 1.8%, 2%, 2.39%, 2.46%, 2.48%, 2.5%, 2.53%, 2.61%, 3%, 3.8%, or 4%. The value of the ratio of the total coverage area of the at least one transparent protrusion on the front surface to the total area of the front surface is not specifically limited herein.

It can be understood that, the ratio of the total coverage area of the at least one transparent protrusion on the front surface to the total area of the front surface is 1 %-4%, can cause the coverage ratio of the transparent protrusion on the front surface to be within an appropriate range, so that the poor anti-scratching effect caused by a too small ratio can be avoided, and an impact on photoelectric conversion efficiency and increased costs caused by an excessive ratio can also be avoided.

Optionally, the ratio of the total coverage area of the transparent protrusion on the front surface to the total area of the front surface is 2%-2.48%, for example, it can be 2%, 2.1%, 2.39%, 2.46%, or 2.48%. Therefore, scratching prevention, photoelectric conversion efficiency, and costs can be taken into consideration, thereby achieving the optimal overall effect.

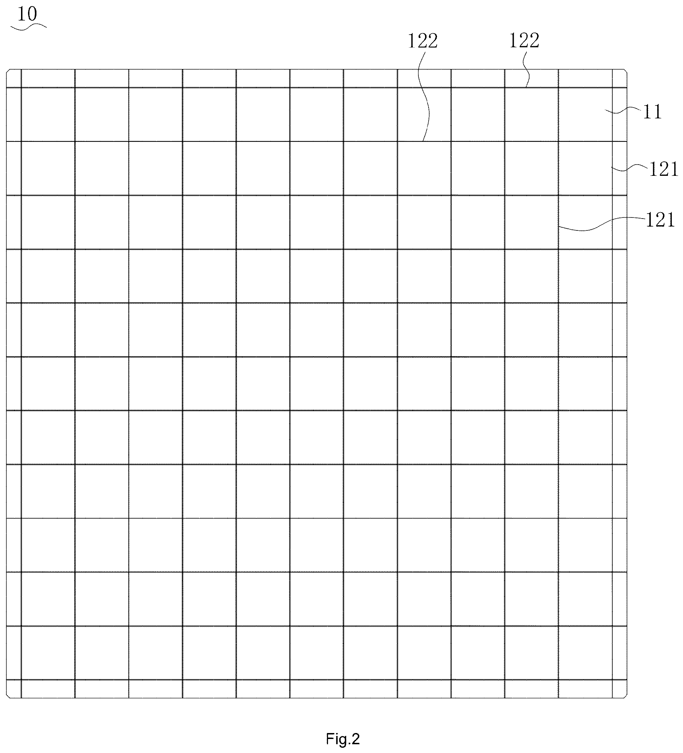

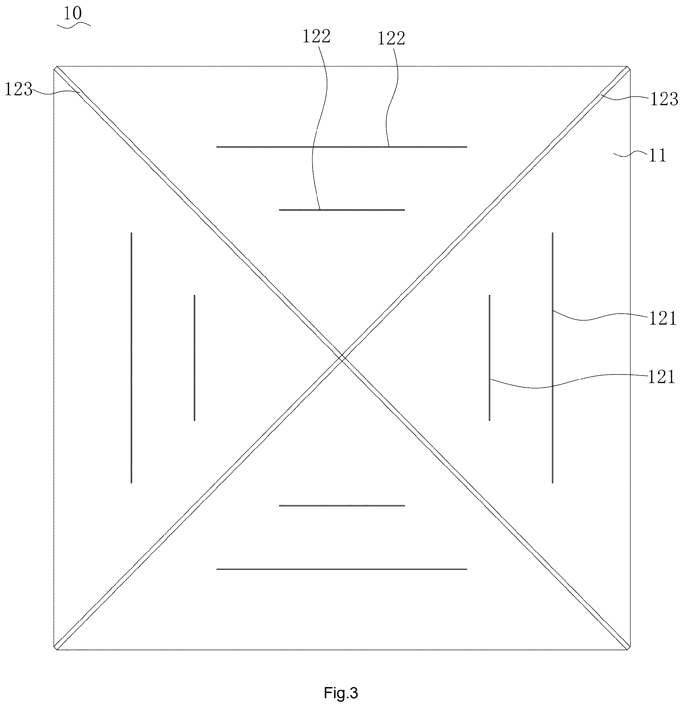

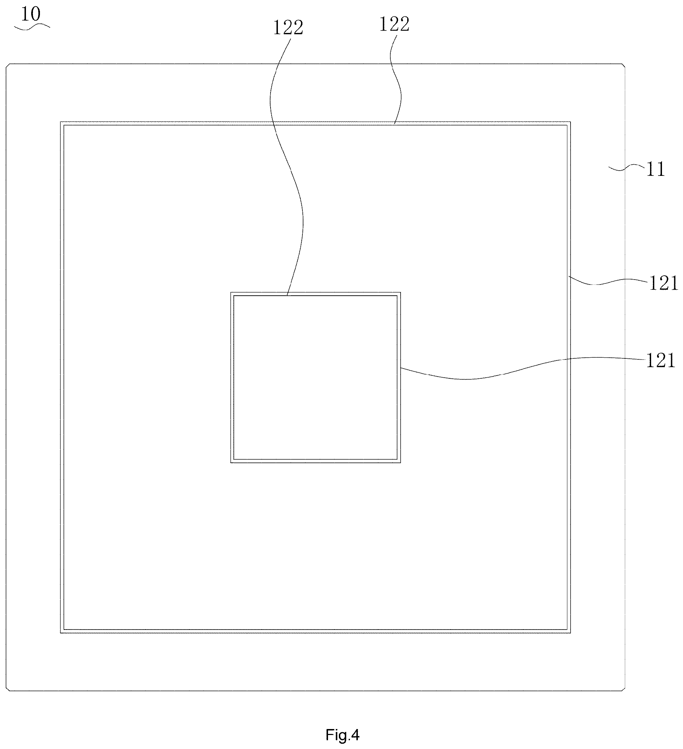

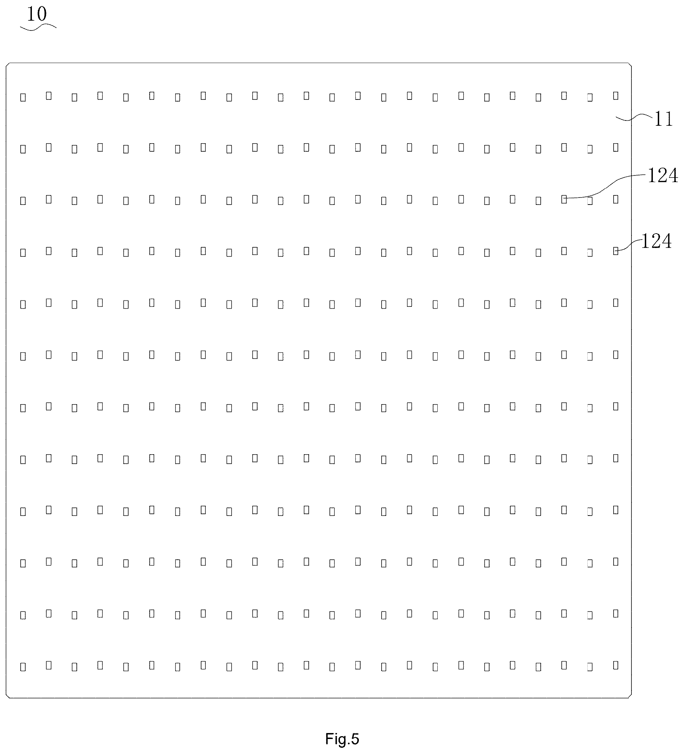

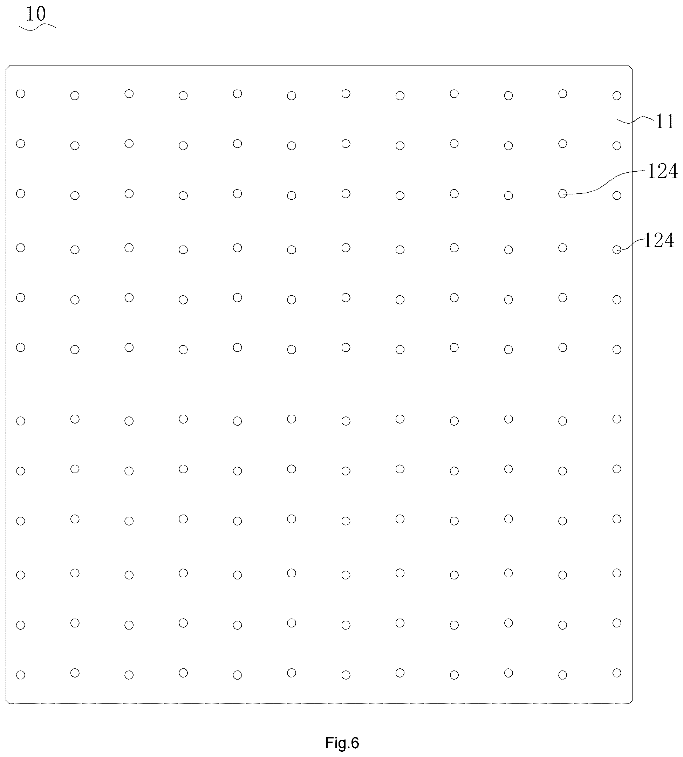

In an embodiment shown in Fig. 1, the ratio of the total coverage area of the transparent protrusion on the front surface to the total area of the front surface is 2.53%; in an embodiment shown in Fig. 2, the ratio of the total coverage area of the transparent protrusion on the front surface to the total area of the front surface is 2.61%; in an embodiment shown in Fig. 3, the ratio of the total coverage area of the transparent protrusion on the front surface to the total area of the front surface is 2.48%; in an embodiment shown in Fig. 4, the ratio of the total coverage area of the transparent protrusion on the front surface to the total area of the front surface is 2.39%; in an embodiment shown in Fig. 5, the ratio of the total coverage area of the transparent protrusion on the front surface to the total area of the front surface is 2.5%; and in an embodiment shown in Fig. 6, the ratio of the total coverage area of the transparent protrusion on the front surface to the total area of the front surface is 2.46%. These are only embodiments, and do not represent a limitation on the ratio.

Specifically, light transmittance of the transparent protrusion is greater than or equal to 80%, for example, it can be 80%, 82%, 85%, 90%, 92%, or 98%. Therefore, the shielding of the transparent protrusion to lights can be reduced, thereby causing more light incident in the back contact cell 10. Optionally, the light transmittance of the transparent protrusion is greater than or equal to 90%. Specifically, the light transmittance of the transparent protrusion can refer to the transmittance of light in a band of 200 nm-350 nm.

Specifically, the transmittance of the light in the band of 200 nm-350 nm by the transparent protrusion is less than the transmittance of light in a band of 500 nm-600 nm. Therefore, more light that can be used by the back contact cell 10 is transmitted by the transparent protrusion, thereby facilitating improvement of the photoelectric conversion efficiency of the back contact cell 10.

Further, the transparent protrusion can be made by a slurry containing at least one kind of light conversion agent. Therefore, light in other bands can be converted into the light in the band of 500 nm-600 nm, such that the transmittance of the light in the band of 500 nm-600 nm is improved.

Specifically, hardness of the transparent protrusion is greater than or equal to 4 H, for example, it can be 4 H, 4.2 H, 4.5 H, 4.8 H, 5 H, or 10 H. Therefore, by causing the hardness of the transparent protrusion within an appropriate range, difficult support of a cell stacked on the front surface of the back contact cell 10 caused by relatively-small hardness can be avoided, such that an effect of preventing the front surface of the back contact cell 10 from being scratched can be achieved.

### Embodiment 2

Referring to Fig. 1, Fig. 2, Fig. 3, and Fig. 4, in some optional embodiments, the transparent protrusion includes first protrusion 121, and the first protrusion 121 is in a strip shape, and an extending direction of the first protrusion 121 is perpendicular to an extending direction of the finger.

Therefore, when another cell is stacked on the front surface of the back contact cell 10, the first protrusion 121 abuts against the fingers of another cell in a vertical direction. When the stacked cell has busbars, its busbars can be abutted against in a direction parallel to the busbars, such that the cell stacked on the front surface of the back contact cell 10 can be better supported. A gap is formed between the two cells, such that the front surface of the back contact cell 10 is prevented from being scratched by the cell stacked on the front surface.

Specifically, the first protrusion 121 can be more than one in number. Therefore, the range for supporting the cell stacked on the front surface of the back contact cell 10 is larger, such that the cell stacked on the front surface of the back contact cell 10 can be better supported, thereby forming the gap between the two cells more stably. It can be understood that, in other embodiments, the first protrusion 121 can also be one in number. The number of the first protrusions 121 is not specifically limited herein.

Specifically, busbars can be formed on the back surface of the substrate 11, and a position of the first protrusion 121 can correspond to a position of the busbars. Therefore, when a cell of which specification is the same as the back contact cell 10 is stacked on the front surface, the first protrusion 121 can exactly abut against its busbars, so as to prevent the busbars from scratching the front surface of the substrate 11.

Specifically, in the embodiments shown in Fig. 1 and Fig. 2, the length of the first protrusion 121 is the same as the length of the substrate 11. In other words, two ends of the first protrusion 121 are respectively connected to two opposite sides of the substrate 11. Therefore, the cell stacked on the front surface of the back contact cell 10 can be better supported in a length direction of the substrate 11.

It can be understood that, the length of the first protrusion 121 can also be less than the length of the substrate 11, as shown in Fig. 3 and Fig. 4. Therefore, costs can be reduced as much as possible while meeting the requirements of supporting.

Specifically, in the embodiments shown in Fig. 1 and Fig. 2, the first protrusion 121 is more than one in number, and the spacing between every two adjacent first protrusions 121 is the same. Therefore, the plurality of first protrusions 121 are uniformly arranged on the front surface of the substrate 11 to support the cell stacked on the front surface of the back contact cell 10, thereby achieving more uniform stress, more stable support, and a better anti-scratching effect.

Further, in the embodiment shown in Fig. 1, the spacing between every two adjacent first protrusions 121 is 6 mm-9 mm, optionally, it is 7.88 mm. In the embodiment shown in Fig. 2, the spacing between every two adjacent first protrusions 121 is 14 mm-17 mm, optionally, it is 15.75 mm.

It can be understood that, the first protrusion 121 is more than one in number, and the spacing between every two adjacent first protrusions 121 can also be different, as shown in Fig. 3. In the embodiment shown in Fig. 3, the spacing between every two right-side first protrusions 121 is 19.94 mm, the spacing between every two left-side first protrusions 121 is 19.94 mm, and the spacing between every two middle first protrusions 121 is 93.24 mm.

It is to be noted that, the spacing between every two adjacent first protrusions 121 here refers to a distance between center lines of every two adjacent first protrusions 121.

### Embodiment 3

In some optional embodiments, a width of each first protrusion 121 is 0.1 mm-2 mm, for example, it can be 0.1 mm, 0.2 mm, 0.5 mm, 0.8 mm, 1 mm, 1.32 mm, 1.39 mm, 1.8 mm, or 2 mm.

Therefore, the width of each first protrusion 121 is within an appropriate range, a poor support effect on the cell stacked on the front surface of the back contact cell 10 caused by a relatively-small width of the first protrusion 121 can be avoided, and an impact on photoelectric conversion efficiency and high costs caused by a relatively-large width of the first protrusion 121 can also be avoided.

### Embodiment 4

In some optional embodiments, a ratio of the length of each first protrusion 121 to a length of the front surface is greater than or equal to 18%, for example, it can be 18%, 20%, 21.45%, 27.17%, 42.89%, 50%, 80%, 81.52%, 98%, or 100%.

Therefore, the ratio of the length of the first protrusion 121 to the length of the front surface is within an appropriate range, and the poor support effect caused by a too small ratio can be avoided.

Specifically, in the embodiments shown in Fig. 1 and Fig. 2, the ratio of the length of the first protrusion 121 to the length of the front surface is 100%. In the embodiment shown in Fig. 3, a ratio of the length of the two first protrusions 121 in the middle to the length of the front surface is 21.45%, and a ratio of the length of the first protrusions 121 on the left side and the right side to the length of the front surface is 42.89%. In the embodiment shown in Fig. 4, a ratio of the length of the two first protrusions 121 in the middle to the length of the front surface is 27.17%, and a ratio of the length of the first protrusions 121 on the left side and the right side to the length of the front surface is 81.52%.

### Embodiment 5

Referring to Fig. 2, Fig. 3, and Fig. 4, in some optional embodiments, the transparent protrusion includes second protrusion 122; an extending direction of the second protrusion 122 is parallel to the extending direction of the finger.

Therefore, when another cell is stacked on the front surface of the back contact cell 10, the second protrusion 122 abuts against the fingers of another cell in a parallel direction. When the stacked cell has busbars, its busbars can be abutted against in a direction vertical to the busbars, such that the cell stacked on the front surface of the back contact cell 10 can be supported in a direction parallel to the extending direction of the finger. A gap is formed between the two cells, such that the front surface of the back contact cell 10 is prevented from being scratched by the cell stacked on the front surface.

Specifically, the second protrusion 122 can be more than one in number. Therefore, the range for supporting the cell stacked on the front surface of the back contact cell 10 is larger, such that the cell stacked on the front surface of the back contact cell 10 can be better supported, thereby forming the gap between the two cells more stably. It can be understood that, in other embodiments, the second protrusion 122 can also be one in number. The number of the second protrusions 122 is not specifically limited herein.

Specifically, in the embodiment shown in Fig. 2, a length of the second protrusion 122 is the same as the width of the substrate 11. In other words, two ends of the second protrusion 122 are respectively connected to the two opposite sides of the substrate 11. Therefore, the cell stacked on the front surface of the back contact cell 10 can be better supported in a width direction of the substrate 11.

It can be understood that, the length of the second protrusion 122 can also be less than the width of the substrate 11, as shown in Fig. 3 and Fig. 4. Therefore, costs can be reduced as much as possible while meeting the requirements of supporting.

Specifically, a width range of the second protrusion 122 can be the same as a width range of the first protrusion 121. The width of the second protrusion 122 can be described by referring to the foregoing description about the width of the first protrusion 121. In order to avoid redundancy, details are not described herein again.

Specifically, in the embodiment shown in Fig. 2, the second protrusion 122 is more than one in number, and the spacing between every two adjacent second protrusions 122 is the same. Therefore, the plurality of second protrusions 122 are uniformly arranged on the front surface of the substrate 11 to support the cell stacked on the front surface of the back contact cell 10, thereby achieving more uniform stress, more stable support, and a better anti-scratching effect.

Further, in the embodiment shown in Fig. 2, the spacing between every two adjacent second protrusions 122 is 14 mm-17 mm, optionally, it can be 15.75 mm.

It can be understood that, the second protrusion 122 is more than one in number, and the spacing between every two adjacent second protrusions 122 can also be different, as shown in Fig. 3. In the embodiment shown in Fig. 3, the spacing between two upper second protrusions 122 is 19.94 mm, the spacing between two lower second protrusions 122 is 19.94 mm, and the spacing between two middle second protrusions 122 is 93.24 mm.

It is to be noted that, the spacing between every two adjacent second protrusions 122 here refers to a distance between center lines of every two adjacent second protrusions 122.

Specifically, the second protrusion 122 can intersect with the first protrusion 121, as shown in Fig. 2. A gap can be formed between an end of the second protrusion 122 and the first protrusion 121, as shown in Fig. 3. The second protrusion 122 can be connected to an end of the first protrusion 121, as shown in Fig. 4. A position relationship between the second protrusion 122 and the first protrusion 121 is not specifically limited herein.

### Embodiment 6

Referring to Fig. 3, in some optional embodiments, the at least one transparent protrusion includes at least one third protrusion 123, the at least one third protrusion 123 is distributed along at least one diagonal of the front surface.

Therefore, when another cell is stacked on the front surface of the back contact cell 10, each of the third protrusion 123 abuts against a grid line of another cell in a diagonal direction, such that the cell stacked on the front surface of the back contact cell 10 can be supported in the diagonal direction. A gap is formed between two cells, such that the front surface of the back contact cell 10 is prevented from being scratched by the cell stacked on the front surface.

Specifically, in the embodiment shown in Fig. 3, the third protrusions 123 are continuously distributed along a diagonal. It can be understood that, in other examples, the third protrusions 123 can also be intermittently distributed along the diagonal. The arrangement mode of the third protrusions 123 is not specifically limited herein.

A width range of the third protrusion 123 can be the same as the width range of the first protrusion 121. The width of the third protrusion 123 can be described by referring to the foregoing description about the width of the first protrusion 121. In order to avoid redundancy, details are not described herein again.

### Embodiment 7

Referring to Fig. 5 and Fig. 6, in some optional embodiments, the transparent protrusion includes fourth protrusion 124, and each fourth protrusion 124 is in a dot shape, and the fourth protrusion is more than one in number.

Therefore, the cell stacked on the front surface of the back contact cell 10 can be supported in the form of dot-shaped protrusions, and a gap is formed between the two cells, such that the front surface of the back contact cell 10 is prevented from being scratched by the cell stacked on the front surface. Furthermore, because each of the fourth protrusions 124 is in a dot shape, a coverage area of the fourth protrusion 124 can be reduced while a large support range is ensured, such that costs can be reduced.

Specifically, the shape of each of the fourth protrusions 124 can be circular, rectangular, triangular, annular, oval, or other shapes. The shapes of the plurality of fourth protrusions 124 can be the same or different. The shape of the fourth protrusion 124 is not specifically limited herein.

Specifically, in the direction perpendicular to the extending direction of the finger, the plurality of fourth protrusions 124 are aligned. Therefore, the plurality of fourth protrusions 124 are all located in the direction perpendicular to the extending direction of the finger, and have a better support effect on the cell stacked on the front surface of the back contact cell 10. It can be understood that, in other embodiments, it can also be that, in the direction perpendicular to the extending direction of the finger, at least one of the plurality of fourth protrusions 124 is staggered.

Specifically, the plurality of fourth protrusions 124 can be uniformly distributed on the front surface. In other words, the spacing between every two adjacent fourth protrusions 124 is the same. Therefore, the fourth protrusions 124 are uniform in stress, thereby achieving more stable support and a better anti-scratching effect.

It can be understood that, in other embodiments, for the plurality of fourth protrusions124, the spacing of every two adjacent fourth protrusions 124 can be completely different from that of others, or can also be partially same as that of others while the rest are different. A position relationship of the plurality of fourth protrusions 124 is not specifically limited herein.

### Embodiment 8

Referring to Fig. 5 and Fig. 6, in some optional embodiments, an area of each fourth protrusion 124 is 2 mm²-6 mm², for example, it can be 2 mm², 2.2 mm², 2.5 mm², 2.91 mm², 3.5 mm², 5.72 mm², or 6 mm².

Therefore, the area of each fourth protrusion 124 is within an appropriate range, unstable support caused by a too small area can be avoided, and an impact on photoelectric conversion efficiency and high costs caused by a too large area can also be avoided.

In the embodiment shown in Fig. 5, the shape of each fourth protrusions 124 is rectangular, and a width of each fourth protrusion 124 is 1.32 mm, and a length of each fourth protrusion 124 is 2.2 mm, and a coverage area of each fourth protrusion 124 is 2.91 mm², and there are 288 fourth protrusions 124 in total, and a total coverage area of all the fourth protrusions 124 is 838.08 mm².

In the embodiment shown in Fig. 6, the shape of each fourth protrusion 124 is circular, and a radius of each fourth protrusion 124 is 1.35 mm, and the coverage area of each fourth protrusion 124 is 5.72 mm², and there are 144 fourth protrusions 124 in total, and the total coverage area of all the fourth protrusions 124 is 823.68 mm².

### Embodiment 9

A cell assembly in this embodiment of the present disclosure includes any one of the back contact cells in the Embodiment 1 to the Embodiment 8.

In the cell assembly in this embodiment of the present disclosure, since each transparent protrusion, which is disposed on the front surface of the substrate 11, has the thickness of 28 µm-98 µm, and the total coverage area of the at least one transparent protrusion having the ratio of 1% -4% with respect to the total area of the front surface, when another cell is stacked on the front surface of the back contact cell 10, there will be a gap between the two cells, so as to prevent the cell stacked on the front surface of the back contact cell 10 from scratching the front surface of the back contact cell, thereby facilitating improvement of the quality of the back contact cell 10.

In this embodiment, the plurality of back contact cells 10 in the cell assembly can be sequentially connected in series to form a cell string, so as to realize series convergence output of currents, for example, the serial connection of cells can be implemented by means of disposing soldering ribbons (also be called busbars or interconnection bars) and disposing a conductive backsheet, but it's not limited to these.

It can be understood that, in such an embodiment, the cell assembly can further include a metal frame, a backsheet, a photovoltaic glass, and an adhesive film. The adhesive film can be filled between the front side and back side of the back contact cell 10 and the photovoltaic glass, or the adjacent cells. As a filler, the adhesive film can be a transparent colloid with good transmittance performance and good aging resistance performance. For example, the adhesive film can be an EVA adhesive film or a POE adhesive film, which can be specifically selected according to actual situations, and is not limited herein.

The photovoltaic glass can be covered on the adhesive film of the front surface of the back contact cell 10. The photovoltaic glass can be ultra clear glass, which has high transmittance, high transparency, and excellent physical, mechanical, and optical properties. For example, the transmittance of the ultra-clear glass can reach over 92%, and the ultra-clear glass can protect the back contact cell 10 without affecting the efficiency of the back contact cell 10 as much as possible. Furthermore, the adhesive film can bond the photovoltaic glass and the back contact cell 10 together, and the presence of the adhesive film can perform sealed insulation and protection against water and moisture on the back contact cell 10.

The backsheet can be attached to the adhesive film on the back side of the back contact cell 10. The backsheet can protect and support the back contact cell 10, and has reliable insulation, water resistance, and aging resistance. The backsheet can have various options, and usually can be a tempered glass, an organic glass, or an aluminum alloy TPT composite adhesive film, which can specifically be designed according to specific situations, and is not limited herein. An integral whole consisting of the backsheet, the back contact cell 10, the adhesive film, and the photovoltaic glass can be disposed on the metal frame. The metal frame, as a main external support structure of the entire cell assembly, can perform stable support and mounting on the cell assembly, for example, the cell assembly can be mounted, through the metal frame, in a position required to be mounted.

### Embodiment 10

A photovoltaic system in this embodiment of the present disclosure includes the cell assembly in Embodiment 9.

In the photovoltaic system in this embodiment of the present disclosure, since each transparent protrusion, which is disposed on the front surface of the substrate 11, has the thickness of 28 µm-98 µm, and the total coverage area of the at least one transparent protrusion having the ratio of 1% -4% with respect to the total area of the front surface, when another cell is stacked on the front surface of the back contact cell 10, there will be a gap between the two cells, so as to prevent the cell stacked on the front surface of the back contact cell 10 from scratching the front surface of the back contact cell, thereby facilitating improvement of the quality of the back contact cell 10.

In this embodiment, the photovoltaic system can be applied to a photovoltaic power station such as a surface power station, a rooftop power station, a water surface power station, or can also be applied to a device or an apparatus that uses solar energy for power generation, such as a user solar power supply, a solar street lamp, a solar car, or a solar building. It can be understood that, the application scenarios of the photovoltaic system are not limited thereto, that is, the photovoltaic system can be used in all fields where solar energy is required for power generation. By using a photovoltaic power generation system network as an example, the photovoltaic system can include a photovoltaic array, a combiner box, and an inverter. The photovoltaic array can be an array combination of a plurality of cell assemblies. For example, a plurality of cell assemblies can constitute a plurality of photovoltaic arrays. The photovoltaic array is connected to the combiner box. The combiner box can converge currents generated by the photovoltaic array, and the converged currents are converted into alternating currents required by the municipal power grid by passing through the inverter, and then are connected to the municipal power network, so as to realize solar power supply.

In the description of the specification, descriptions of the terms "some embodiments," "exemplary embodiment", "example," "specific example," or "some examples", mean that specific features, structures, materials, or characteristics described with reference to the implementations or examples are included in at least one implementation or example of the present disclosure. In this specification, schematic representations of the above terms do not necessarily refer to the same embodiment or example. In addition, the described particular features, structures, materials or characteristics may be combined in any suitable manner in any one or more embodiments or examples.

Furthermore, the above are merely preferred embodiments of the present disclosure, but are not intended to limit the present disclosure. Any modification, equivalent replacement, improvement, or the like made within the spirit and principle of the present disclosure should fall within the protection scope of the present disclosure.

## Claims

1. A back contact cell, comprising a substrate and at least one transparent protrusion, wherein two kinds of fingers distributed in a staggered manner are formed on a back surface of the substrate, the at least one transparent protrusion is formed on a front surface of the substrate, a thickness of each transparent protrusion is 28 µm-98 µm, and a ratio of a total coverage area of the at least one transparent protrusion on the front surface to a total area of the front surface is 1%-4%.

2. The back contact cell according to claim 1, wherein the at least one transparent protrusion comprises at least one first protrusion, and the first protrusion is in a strip shape, and an extending direction of the first protrusion is perpendicular to an extending direction of the finger.

3. The back contact cell according to claim 2, wherein a width of each first protrusion is 0.1 mm-2 mm.

4. The back contact cell according to claim 2, wherein a ratio of a length of each first protrusion to a length of the front surface is greater than or equal to 18%.

5. The back contact cell according to claim 1, wherein the at least one transparent protrusion comprises at least one second protrusion, and an extending direction of the second protrusion is parallel to an extending direction of the finger.

6. The back contact cell according to claim 1, wherein the at least one transparent protrusion comprises at least one third protrusion, and the third protrusion is distributed along at least one diagonal of the front surface.

7. The back contact cell according to claim 1, wherein the at least one transparent protrusion comprises fourth protrusions, and each of the fourth protrusions is in a dot shape.

8. The back contact cell according to claim 7, wherein an area of each of the fourth protrusions is 2 mm²-6 mm².

9. A cell assembly, comprising the back contact cell according to any one of claims 1 to 8.

10. A photovoltaic system, comprising the cell assembly according to claim 9.
